# EUROPEAN PATENT APPLICATION

(11) **EP 1 939 599 A2**
(43) Date of publication of application: **02.07.2008**
(21) Application number: 07123556.8
(22) Date of filing: 19.12.2007
(51) Int. Cl.: G01L 9/00

(54) **Pressure transducer diaphragm and method of making same**

(30) Priority: 29.12.2006 US 617808
(71) Applicant: General Electric Company, Schenectady, NY 12345 (US)
(72) Inventor: Craddock, Russell William, Stoke Golding, Leicestershire CV13 6HS (GB); Kinnell, Peter Ken, Quorn, Leicestershire LE12 8HJ (GB)
(74) Representative: Bedford, Grant Richard

(57) **Abstract**

A method of making a pressure transducer diaphragm 10. One or more trenches 54 are etched in a first surface 63 of a first substrate 50. The trench is rendered etch resistant. A cavity 60 is then formed in a second opposite surface of the first substrate defining a diaphragm supported by a frame with one or more hollow bosses 14 stiffening the membrane.

## Description

This subject invention relates generally to pressure transducers.

Microelectromechanical pressure sensors typically include a diaphragm or membrane supported by a frame. It is known to fabricate the diaphragm to include thinner and thicker areas called bosses. See U.S. Patent No. 6,140,143 incorporated herein by this reference. The thicker boss areas concentrate the stress created by deflection of the diaphragm. The bosses may be used to concentrate bending stresses in stress sensing piezoresistors or capacitive elements. The bosses can also be used to produce a sensing capacitance or an electrostatic drive gap by fabricating close adjacent structure.

Typically, the bosses are solid structures created by diffusion of material into a substrate at different depths and then etching the substrate. See Patent No. 6,140,143 referenced above.

Prior bosses have a significant mass which, in the case of low pressure sensors, can result in orientation sensitivity. The thickness of the boss is also limited to the depth at which material can be infused into the substrate. In general, deeper infusions involve an added expense and increased time. Also, the width of the resulting boss structure increases because diffusion occurs both vertically and laterally in the substrate.

According to a first aspect, the present invention provides a new method of making a pressure transducer diaphragm. The method can result in bosses with less mass. The resulting bosses are preferably hollow. The method results in higher stiffness bosses. The resulting bosses can be created using lower cost processing techniques. The bosses are lighter than solid structures of equal stiffness. Provided is a pressure transducer with less g-sensitivity. Bosses of arbitrary width and stiffness can be produced. Provided is the ability to vary the configuration of the bosses as desired.

Various aspects of the present invention result from the realization that a better method of producing a pressure transducer diaphragm without the limitations associated with diffusion and bulk etching includes etching a trench in a substrate to define a hollow boss lower in mass but also relatively stiff.

Various aspects of the present invention, however, in other embodiments, need not achieve all these objectives and the claims hereof should not be limited to structures or methods capable of achieving these objectives.

One aspect of the present invention features a method of making a pressure transducer diaphragm. One or more trenches are formed (e.g., etched) in a first surface of a first substrate. The trench is then rendered etch resistant. A cavity is formed (e.g., etched) in a second opposite surface of the first substrate defining a diaphragm supported by a frame with one or more hollow bosses stiffening the membrane.

Dry etching or wet etching techniques can be used to form the trenches. In one example, the one or more trenches have angled side walls. In another example, the one or more trenches have a flat bottom.

The trench can be rendered etch resistant by doping the trench, diffusing the trench, or adding an etch resistant material to the trench. Also, material can be added to the trench. For example, polysilicon or epitaxial silicon layers can be grown in the trench.

In one example, a second substrate is bonded to the first surface of the first substrate. The second substrate can fusion bonded to the first surface of the first substrate. The cavity can be formed using dry or wet etching techniques.

In one embodiment, a pressure transducer diaphragm is made by etching one or more trenches in a first surface of a first substrate, rendering the trench and the first surface etch resistant, and etching a cavity in a second opposite surface of the first substrate defining a diaphragm supported by a frame with one or more hollow bosses stiffening the membrane.

In another embodiment, a pressure transducer diaphragm is made by etching one or more trenches in a first surface of a first substrate, rendering the trench etch resistant, bonding a second substrate to the first surface, and etching a cavity in a second opposite surface of the first substrate defining a diaphragm supported by a frame with one or more hollow bosses stiffening the membrane.

Various objects, features and advantages of the present invention will occur to those skilled in the art from the following description of a preferred embodiment and the accompanying drawings, in which:
Fig. 1 is a schematic top view showing an example of a pressure transducer diaphragm in accordance with an embodiment of the present invention;
Fig. 2 is a schematic three-dimensional isometric view of the pressure transducer diaphragm shown in Fig. 1;
Fig. 3 is a schematic cross-sectional view of a portion of the pressure transducer diaphragm shown in Fig. 2 taken a long line 3-3 of Fig. 2;
Fig. 4 is a schematic partial cross-sectional view showing a portion of another example of a pressure transducer diaphragm in accordance with an embodiment of the present invention;
Fig. 5 is a schematic cross-sectional partial view of still another example of a pressure transducer diaphragm in accordance with an embodiment of the present invention;
Figs. 6A-6G are highly schematic cross-sectional views depicting the primary steps associated with making a pressure transducer diaphragm in accordance with one embodiment of the present invention;
Figs. 7A-7F are highly schematic cross-sectional views showing a primary steps associated with another method of making a pressure transducer diaphragm in accordance with an embodiment of the present invention; and
Fig. 8 is a schematic three-dimensional cross-sectional view showing an example of a complete MEMS pressure transducer in accordance with an embodiment of the present invention.

Aside from the preferred embodiment or embodiments disclosed below, this invention is capable of other embodiments and of being practiced or being carried out in various ways. Thus, it is to be understood that the invention is not limited in its application to the details of construction and the arrangements of components set forth in the following description or illustrated in the drawings. If only one embodiment is described herein, the claims hereof are not to be limited to that embodiment. Moreover, the claims hereof are not to be read restrictively unless there is clear and convincing evidence manifesting a certain exclusion, restriction, or disclaimer.

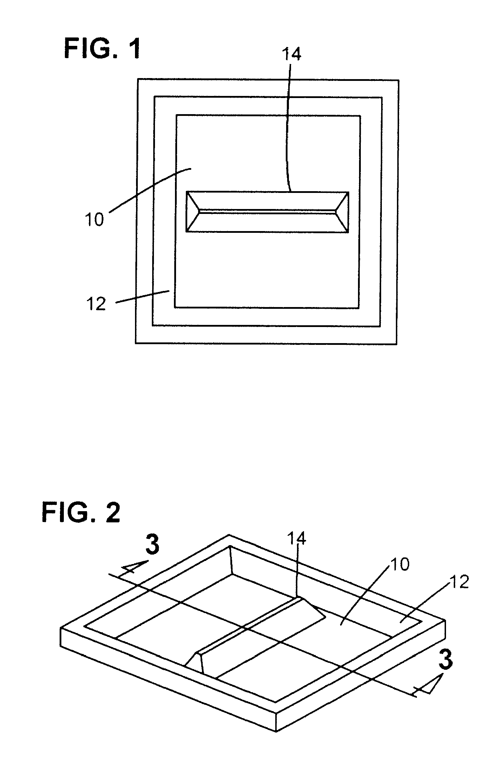

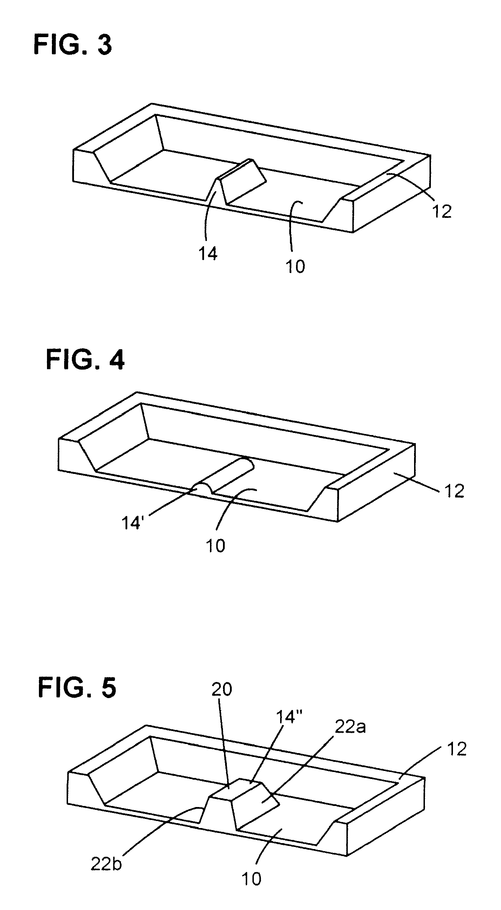

Figs. 1-2 depict an example of a pressure transducer diaphragm or membrane 10 in accordance with an embodiment of the present invention. Diaphragm 10 is supported by frame 12 and includes hollow boss or mesa 14. Additional bosses may traverse diaphragm 10. Typically, there are a number of bosses but only one is shown in the figures here for clarity. Diaphragm 10 in one particular example is 2.4 mm square, and 5 microns thick. Boss 14, Fig. 3 has angled side walls 16a and 16b with a wall thickness of 5 microns. Boss 14 can be formed in different configurations, however, as shown in Fig. 4 where boss 14' is smaller and in Fig. 5 where boss 14" has a flat surface 20 and two angled side walls 22a and 22b.

In any configuration, the hollow boss or bosses have less mass than solid bosses and yet provide high stiffness. The result is, in one example, a pressure transducer with less g-sensitivity.

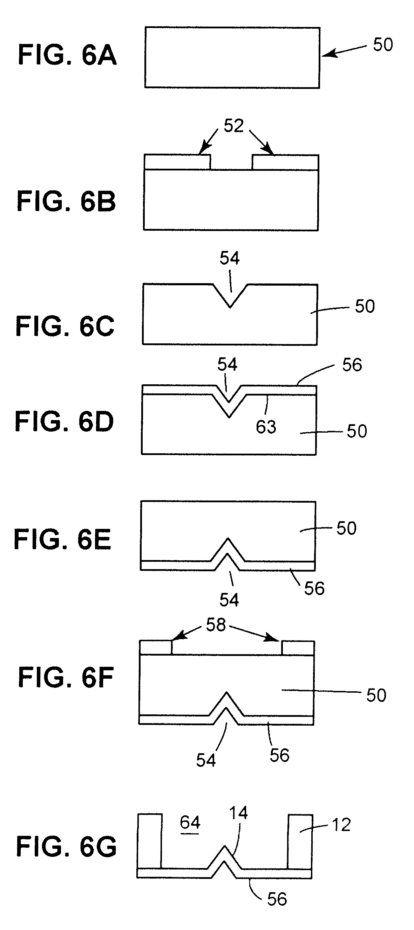

As shown in Figs. 6A-6G, substrate 50, Fig. 6A (typically a silicon wafer) is masked as shown at 52, Fig. 6B and trench 54 is etched, Fig. 6C. Dry or wet etching techniques can be used. Trench 54 and surface 63 of substrate 50 are then rendered etch resistant typically by implanting phosphorous as shown at 56 in Fig. 6D. The junction formed by the implanted phosphorous in conjunction with an electrochemical etch stop prevents etching of the implanted regions. See U.S. Patent No. 6,140,143 incorporated herein by this reference. The wafer is then turned over, Fig. 6E and masked as shown at 58. Then, this surface of the wafer is etched to produce cavity 60, membrane 10 supported by frame 12, and hollow boss 14.

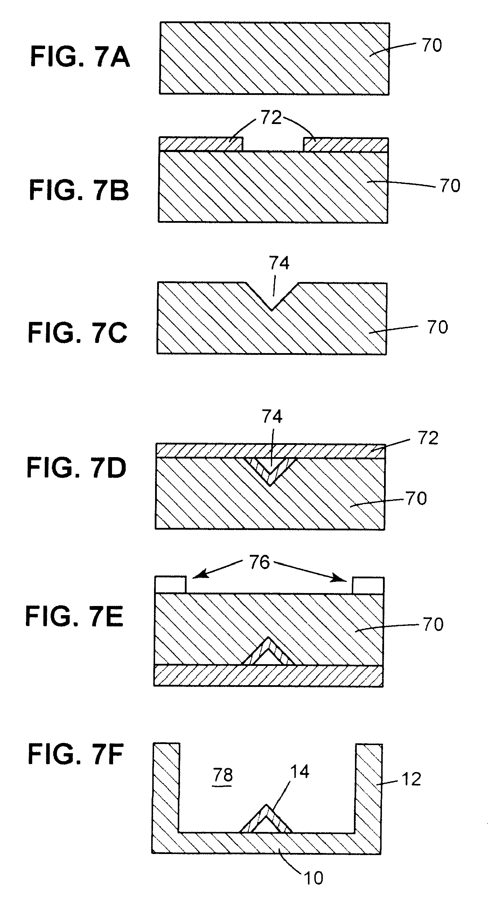

In another example, wafer 70, Fig. 7A is masked as shown at 72 in Fig. 7B and trench 74 is etched using dry or wet etching techniques. Trench 74 has angled side walls as shown. Trench 74 is then rendered etch resistant by doping the trench (with Boron, for example), or diffusing the trench using n-type diffusion and using an electrochemical etch stop as discussed above, or adding the etch resistant material to the trench such as etch resistant dielectrics or metals to create etch resistant side walls. Polysilicon or epitaxial silicon layers can be grown above the etch resistant layer if required to increase the thickness of the side walls of the resulting boss. Wafer 72, (also typically a silicon wafer) Fig. 7D is then bonded to substrate 70 over trench 74 by fusion bonding techniques or by using intermediate layers as is known in the art. This structure is then turned over and masking 76, Fig. 7E applied so cavity 78 can be wet or dry etched resulting in membrane 10 with boss 14 and frame 12.

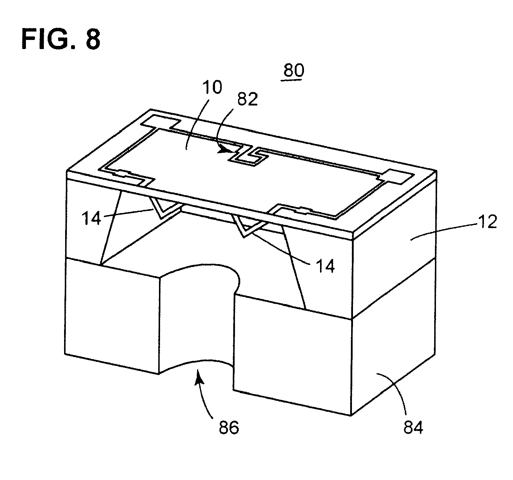

In one example, the diaphragm is a component of MEMS pressure transducer 80, Fig. 8. Two bosses 14 are shown here on diaphragm 10 (n-type) which also includes diffused piezoresistor 82. Frame 12 is P-type and resides on pyrex support 84 with port 86. The method of an embodiment of the present invention, however, is not limited to any specific pressure sensor design.

The hollow boss technology of an embodiment of the present invention allows hollow shell-type features to be fabricated on thin diaphragms typically used in pressure sensors to provide areas of localized stiffness on an otherwise flexible membrane. The walls of the hollow boss structure are typically of a similar dimension to the membrane itself, however, there are hollow corrugated shape means renders them significantly stiffer. By forming (e.g., etching) the front side of a silicon wafer and producing an etch stop in the base of the etched trench, the boss will not be etched when the back side of the wafer is etched when the membrane structure is produced. The etch stop for the trench can be a high doped P+ diffusion, a low doped n-type diffusion (for an electrochemical etch stop), or an etch resistant layer such as silicon dioxide. In some examples, it may be advantageous to bond a further silicon layer as shown in Fig. 7D over the trench to further stiffen the structure. This technique also has the advantage of recreating a planar wafer surface for further wafer processing. The additional silicon layer can be bonded by either intermediate layers such as glass for electrostatic bonding or by silicon fusion bonding (also known as silicon direct bonding). Wet etching advantageously is able to produce a side wall at approximately 54.7° to the wafer surface. In this way, a minimum boss width of approximately 1.4 times the wafer thickness can be produced. As a typical sensor wafer is 380 µm thick, this produces a 532 µm wide boss. Dry etching has the advantage of a vertical side wall etch. Narrow or arbitrary boss shapes are also possible. The resulting boss can be shallower than a solid boss, or have less mass, and yet be as stiff as the solid boss.

The result is a low pressure sensor which does not suffer from orientation sensitivity due to the mass of the boss. Boss stiffness is not limited by diffusion depth of approximately 30 µm associated with prior art techniques. Hollow bosses of an embodiment of the present invention have a stiffness significantly higher than an equivalent amount of material creating a solid boss of equal surface shape and area. A narrow stiff boss can be created with conventional low cost processing techniques avoiding more expansive DRIE techniques if desired. The backside etch which forms the cavity in the final membrane structure could be any technique capable of creating the frame structure and etching down to the final membrane such as wet etching but DRIE etching might also be used with an oxide coated side wall. Typically, the technique of an embodiment of the present invention produces stiff boss structures smaller and less costly than other methods resulting in lighter and less g-sensitive boss structures. In one example, the boss structure had a wall thickness of 15 µm and a base 20 µm wide to 130 µm wide.

Although specific features of the invention are shown in some drawings and not in others, however, this is for convenience only as each feature may be combined with any or all of the other features in accordance with the invention. The words "including", "comprising", "having", and "with" as used herein are to be interpreted broadly and comprehensively and are not limited to any physical interconnection. Moreover, any embodiments disclosed in the subject application are not to be taken as the only possible embodiments.

Other embodiments will occur to those skilled in the art and are within the following claims. For example, the method of this invention may prove useful for creating diaphragms for devices other than pressure transducers.

In addition, any amendment presented during the prosecution of the patent application for this patent is not a disclaimer of any claim element presented in the application as filed: those skilled in the art cannot reasonably be expected to draft a claim that would literally encompass all possible equivalents, many equivalents will be unforeseeable at the time of the amendment and are beyond a fair interpretation of what is to be surrendered (if anything), the rationale underlying the amendment may bear no more than a tangential relation to many equivalents, and/or there are many other reasons the applicant can not be expected to describe certain insubstantial substitutes for any claim element amended.

## Claims

1. A method of making a pressure transducer diaphragm (10), the method comprising:
etching one or more trenches (54) in a first surface (63) of a first substrate (50);
rendering the trench etch resistant; and
etching a cavity (60) in a second opposite surface of the first substrate defining a diaphragm supported by a frame with one or more hollow bosses stiffening the membrane.

2. The method of claim 1 in which etching the one or more trenches (54) includes dry etching or wet etching.

3. The method of any preceding claim in which the one or more trenches (54) have angled side walls.

4. The method of any preceding claim in which the one or more trenches (54) have a flat bottom.

5. The method of any preceding claim in which rendering the trench (54) etch resistant includes doping the trench, diffusing the trench, or adding an etch resistant material to the trench.

6. The method of any preceding claim further including the step of adding material to the trench (54).

7. The method of any preceding claim in which polysilicon or epitaxial silicon layers are grown in the trench (54).

8. The method of any preceding claim in which a second substrate is bonded to the first surface (63) of the first substrate (50).

9. The method of any preceding claim in which the second substrate is fusion bonded to the first surface (63) of the first substrate (50).

10. The method of any preceding claim in which etching the cavity (60) includes dry or wet etching.

11. A method of making a pressure transducer diaphragm (10), the method comprising:
etching one or more trenches (54) in a first surface (63) of a first substrate (50);
rendering the trench and the first surface etch resistant; and
etching a cavity (60) in a second opposite surface of the first substrate defining a diaphragm supported by a frame with one or more hollow bosses stiffening the membrane.

12. A method of making a pressure transducer diaphragm (10), the method comprising:
etching one or more trenches (54) in a first surface (63) of a first substrate (50);
rendering the trench etch resistant;
bonding a second substrate to the first surface; and
etching a cavity (60) in a second opposite surface of the first substrate defining a diaphragm supported by a frame with one or more hollow bosses (14) stiffening the membrane.

13. A method of making a diaphragm (10), the method comprising:
forming one or more trenches (54) in a first surface (63) of a first substrate (50);
rendering the trench etch resistant; and
forming a cavity (60) in a second opposite surface of the first substrate defining a diaphragm supported by a frame with one or more hollow bosses (14) stiffening the membrane.
